# EUROPÄISCHE PATENTSCHRIFT

(11) **EP 1 309 235 B1**
(45) Veröffentlichungstag und Bekanntmachung des Hinweises auf die Patenterteilung: **28.11.2007**
(21) Anmeldenummer: 02024008.1
(22) Anmeldetag: 26.10.2002
(51) Int. Cl.: H05K 3/00, E05C 17/30, C25D 17/02

(54) **Verschlussdeckel für Prozessbehälter**
Closure lid for processing container
Couvercle de fermeture pour récipient de traitement

(30) Priorität: 05.11.2001 DE 20118198 U
(43) Veröffentlichungstag der Anmeldung: 07.05.2003
(73) Patentinhaber: Gebr. Schmid GmbH & Co., D-72250 Freudenstadt (DE)
(72) Erfinder: Schmid, Dieter C., 72250 Freudenstadt (DE)
(74) Vertreter: Patentanwälte Ruff, Wilhelm, Beier, Dauster & Partner

(56) Entgegenhaltungen:
- US-A- 4 486 094
- US-A- 4 925 230
- US-A- 5 022 949
- US-A- 5 575 513

## Beschreibung

Die Erfindung betrifft einen Verschlussdeckel für Prozessbehälter zur Behandlung von elektronischen Bauteilen, wie Leiterplatten.

Prozessbehälter für Leiterplatten haben normalerweise einen trogartigen Aufbau. In ihnen werden die Leiterplatten horizontal liegend mit einem Transportsystem durchtransportiert und dabei normalerweise nassen Behandlungen unterzogen. Dazu sind Sprühdüsen, durchströmte Bäder, Galvanisiereinrichtungen o.dgl. vorgesehen. Wegen der darin bewegten und teilweise versprühten Flüssigkeiten und der Tatsache, dass es sich dabei meist um aggressive Chemikalien handelt, sollten diese Behälter Deckel aufweisen, die jedoch eine Überwachung ermöglichen.

Diese Deckel wiederum sollten aus mechanischen wie aus chemischen Gründen aus Glas bestehen, und zwar aus relativ dickem bruchsicheren Glas. Auch wegen der sehr großen abzudeckenden Flächen werden die Deckel sehr schwer. Zu manuellem Eingriff in den Prozess, beispielsweise zur Beseitigung von Störungen oder für die Reinigung, müssen die Deckel zu öffnen sein. Dabei muss sichergestellt sein, dass sie in ihrer Öffnungsposition sicher gehalten werden. Sie sollen jedoch leicht, aber keinesfalls versehentlich zu schließen sein.

Diese Aufgabe wird durch die Erfindung gemäß dem Anspruch 1 gelöst, wobei der Verschlussdeckel eine insbesondere transparente Deckelplatte hat und der Deckel gelenkig an den Behälter angelenkt ist, eine Deckelhandhabe zur Aufstellung des Deckels in eine Öffnungsposition sowie zwei Stützen aufweist, die den Deckel in der Öffnungsposition halten. Die Stützen weisen zwei am Deckel bzw. im Behälter angelenkte Stützenabschnitte auf, die von einer verkürzten Schließposition der Stütze in deren verlängerte Öffnungsposition beweglich sind. Sie enthalten eine Raste, die die Stütze in der Öffnungsposition sichert, wobei die Raste durch eine Fluchtungsänderung eines ersten Stützenabschnittes gegenüber dem anderen Stützenabschnitt ein- bzw. ausrastbar ist und die erste Stützenabschnitte beider Stützen durch ein Entriegelungsglied miteinander verbunden sind, das eine Entriegelungshandhabe aufweist.

Dies stellt sicher, dass der Verschlussdeckel durch zwei normalerweise an den seitlichen Rändern des Deckels angreifende Stützen sicher gehalten werden. Diese sind in ihrer Öffnungsposition verriegelt, wobei sie automatisch in diese Öffnungsposition einfallen. Durch einen entsprechenden Hinterschnitt an einer Rastausnehmung kann ein versehentliches Entriegeln ausgeschlossen werden. Um jedoch eine gewollte Entriegelung beider Seiten gleichzeitig zu ermöglichen, verbindet die Entriegelungshandhabe die beiden Stützen miteinander. Der Deckel muss also erst ein Stück angehoben werden und dann kann die Entriegelungshandhabe betätigt werden, um die Stütze teleskopartig zusammenschieben zu können. Wenn dagegen der Bediener versehentlich gegen den Deckel stößt und ihn etwas anhebt, bleibt die Raste eingerastet, weil das Entriegelungsglied entgegen einer Kraft, insbesondere der Schwerkraft, zu betätigen ist.

Das Entriegelungsglied kann eine Verbindungsstange zwischen den ersten Stützenabschnitten beider Stützen sein, indem sie beispielsweise ihre gemeinsame Achse bildet.

Die beiden Stützenabschnitte können ineinander geführt sein, wobei der erste Stützenabschnitt die Raste in Form eines Schlitzes bzw. einer Ausnehmung an einer Seite, vorzugsweise der nach oben weisenden Seite, ist. Danach erstreckt sich der erste Stützenabschnitt mit verringerten Querabmessungen weiter bis zu einem Kopf an ihrem freien Ende, der eine Art Schwenklagerung in der dem zweiten Stützenabschnitt bildet. Infolge der geringeren Breite des ersten Stützenabschnittes zwischen der Raste und dem Kopf kann sich dieser in der vom zweiten Stützenabschnitt gebildeten Führung schräg stellen und somit verrasten.

Die Erfindung schafft eine sehr stabile und betriebssichere Verschlussdeckelkonstruktion, die in ihrem Aufbau mit sehr einfach gestalteten Bauteilen auskommt. Dies ist wichtig, da sie aus Korrosionsgründen bei der meist sehr aggressiven Umgebung aus hochwertigsten Werkstoffen hergestellt werden muss, z.B. aus Titan.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Ausführungsbeispiele der Erfindung sind in den Zeichnungen dargestellt und werden im folgenden näher erläutert.

In den Zeichnungen ist ein Ausführungsbeispiel dargestellt. Es zeigen:
- Fig. 1: eine Seitenansicht des Verschlussdeckels in seiner Öffnungsposition,

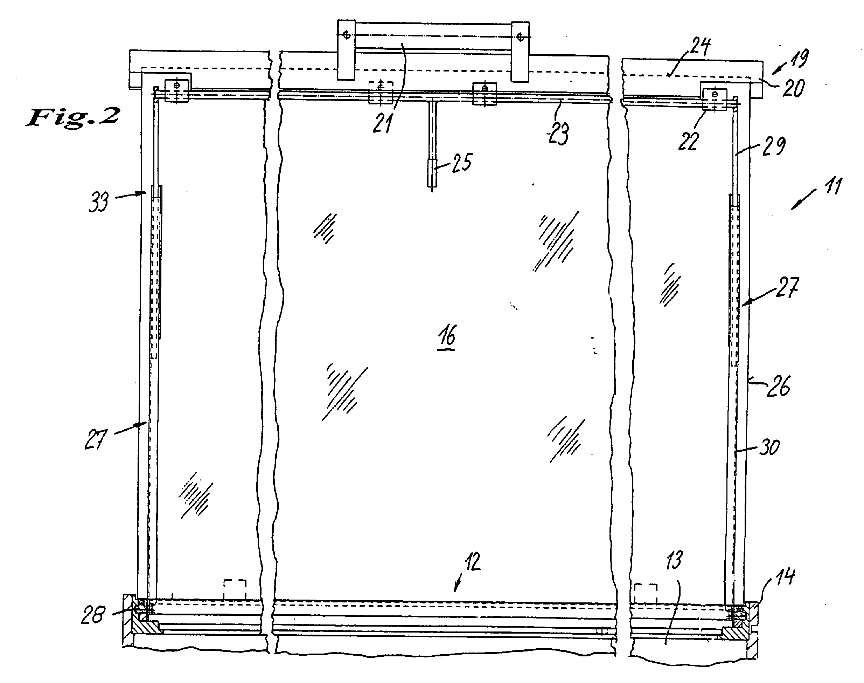

- Fig. 2: eine in der Breite verkürzte Ansicht des Verschlussdeckels in Richtung des Pfeils II in Fig. 1 gesehen,
- Fig. 3: ein vergrößertes Detail aus Fig. 1 und
- Fig. 4: den Verschlussdeckel in seiner Schließposition, im Teilschnitt gesehen.

Die Figuren zeigen einen Verschlussdeckel 11, der die obere, horizontale Öffnung 12 eines Prozessbehälters 13 für die Leiterplattenfertigung bzw. -verarbeitung verschließt. Er liegt auf einem umlaufenden Rahmen 14 des Behälters auf und ist über eine Ringdichtung 15 abgedichtet.

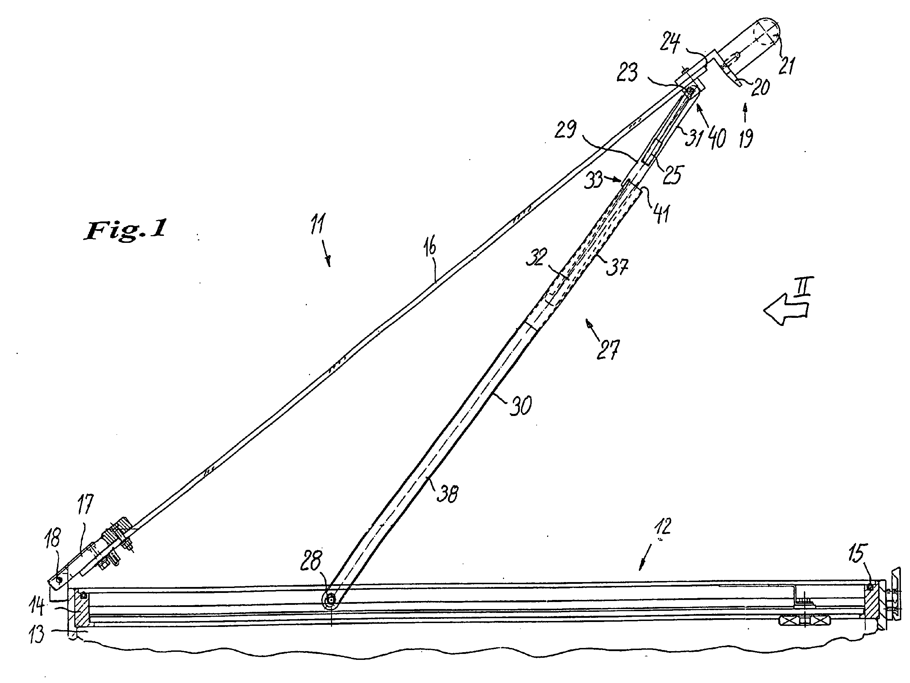

Der Verschlussdeckel 11 weist eine Deckelplatte 16 aus bruchsicherem Glas auf, die im wesentlichen selbsttragend ausgebildet ist. Sie ist über an die Platte angeschraubte Scharnierplatten 17 gelenkig am Behälterrahmen 14 befestigt und um die Achse 18 schwenkbar, bis in die Öffnungsposition, die in Fig. 1 dargestellt ist. Diese ist je nach den Bedürfnissen mehr oder weniger steil; der Öffnungswinkel liegt jedoch deutlich unter 90°.

An der vom Scharnier entfernten Seite der Deckelplatte 16 ist eine Bedienungseinheit 19 befestigt. Sie weist eine über die gesamte Vorderkante 24 der Deckelplatte 16 verlaufende Profilleiste 20 auf, an der ein bügelförmiger Handgriff 21 angebracht ist. An der Unterseite der Profilleiste 20 ist in Lagerböcken 22 eine Stange 23 drehbar gelagert, die parallel zur Profilleiste und damit zur von den Scharnieren entfernten Kante 24 der Deckelplatte 16 verläuft. Sie ist mittels eines Entriegelungshandgriffs 25 schwenkbar.

Auf den freien Enden der Stange 23 sind in Draufsicht parallel zu den Seitenkanten 26 der Deckelplatte 16, Stützen 27 drehfest befestigt, deren anderes Ende um Achsbolzen 28 am Rahmen 14 des Behälters schwenkbar sind.

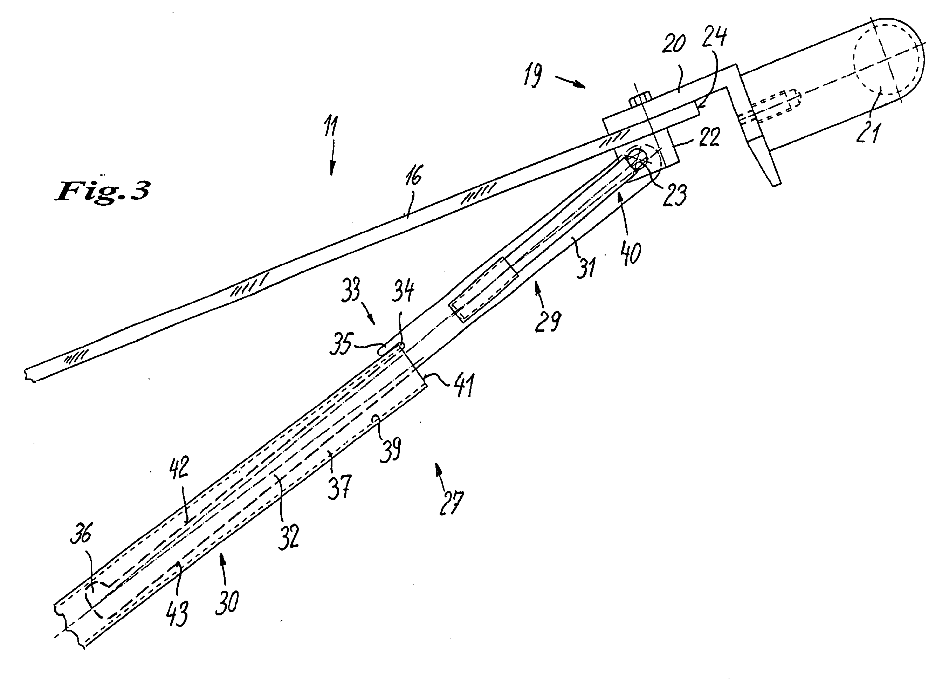

Die Stützen 27 bestehen aus zwei Teilen, nämlich einem ersten Stützenabschnitt 29, der an der Stange 23 befestigte und mit dieser zusammen schwenkbar ist und einem zweiten Stützenabschnitt 30, der am Achsbolzen 28 gelagert ist. Der erste Stützenabschnitt 29 besteht aus kräftigem, leistenförmigen Flachmaterial und hat eine insbesondere aus Fig. 3 hervorgehende Form. Er ist in seinem auf der Stange 23 gelagerten oberen Teil 31 breiter als im unteren, dem freien Ende näheren Teil 32. Zwischen diesen Teilen liegt eine Raste 33, die aus einer oben in den Absatz zwischen den beiden Teilen eingeschnittenen schlitzförmigen Ausnehmung 34 besteht, die damit eine Rastnase 35 abgrenzt. Am freien Ende des unteren Teils 32 befindet sich ein Kopf 36, der etwa die Breite hat wie der obere Teil 31 des ersten Stützenabschnitts 29.

Der zweite Stützenabschnitt 30 hat eine sehr langgestreckte Form, die in seinem oberen Teil 37 die Querschnittsform eines langgestreckten Rechteckrohrs hat, während sie im unteren Teil 38 einen U-förmigen Querschnitt hat.

Der rohrförmige obere Teil 37 bildet eine Führung 39 für den ersten Stützenabschnitt 29, d.h. die Rohrinnenabmessungen sind in dieser Richtung mit entsprechendem Bewegungsspiel an die Außenabmessungen des Kopfes 36 und des oberen Teils 31 angepasst. Der untere Teil 32 des ersten Stützenabschnitts hat dagegen eine geringere Breite als die Führung, in dem zwischen dem Kopf und der Raste 33 dieser Teil wesentlich schmaler ist, als die Innenabmessung der Führung.

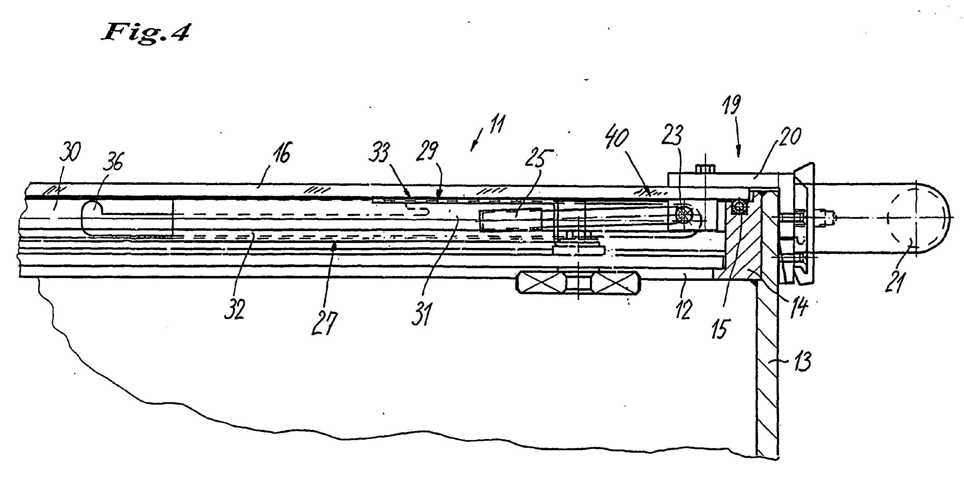

Der Verschlussdeckel arbeitet wie folgt:
In der Schließstellung (Fig. 4) verlaufen die Stützen 27 nahe der Seitenkante der Deckelplatte 16 dicht unterhalb deren Ebene und im wesentlichen parallel dazu. Der erste Stützenabschnitt 29 ist auch mit seinem oberen Teil 31 teilweise in die Führung 39 des zweiten Stützenabschnitts 30 eingefahren. Die Mittelachsen der beiden Stützenabschnitte 1 und 2 fluchten dabei im wesentlichen miteinander. Die drehfest mit der zu einem Entriegelungsglied 40 gehörenden Stange 23 verbundenen ersten Stützenabschnitte sind über die Stange 23 drehfest miteinander verbunden. Die Entriegelungshandhabe 25 liegt im wesentlichen parallel zur Unterseite der Deckelplatte 16. Der Deckel schließt somit den Behälter 13 im wesentlichen dicht ab.

Zum Öffnen ergreift der Bediener den Handgriff 21 und schwenkt den Deckel, der ein erhebliches Gewicht haben kann, nach oben, und zwar in eine noch über Fig. 1 hinausgehende Position. Dabei verlängern sich die zweiteiligen Stützen 27 dadurch, dass die ersten Stützenabschnitte 29 in der Führung 39 des zweiten Stützenabschnittes gleiten. Wenn die Raste 33 die obere Stirnfläche 41 des zweiten Stützenabschnittes 27 erreicht, dann kippt der zweite Stützenabschnitt 30 unter seinem Eigengewicht etwas nach unten und nimmt dabei, ebenfalls unterstützt von dessen Eigengewicht, den ersten Stützenabschnitt mit. Die beiden Stützenabschnitte 29, 30 kommen damit aus der Fluchtung, bilden also mit ihren Längsachsen einen kleinen Winkel zueinander. Dabei schwenkt der erste Stützenabschnitt 29 um den durch den Kopf 36 gebildeten Schwenkpunkt innerhalb der Führung. Das Innere der Führung 39 liegt dann an der oberen, den unteren Teil des ersten Stützenabschnittes verschmälernden Kante 42 an. Wenn der Bediener jetzt den Handgriff los lässt oder den Deckel wieder absenkt, dann greift die Stirnfläche 41 in die schlitzförmige Ausdehnung 34 ein und die Rastnase 35 sichert die beiden Teile in dieser Position, und zwar unter ihrem Eigengewicht und den darauf lastenden Gewicht des gesamten Deckels. Das Erreichen der Rastposition wird dem Bediener auch merklich bzw. akustisch signalisiert, wenn nämlich die beiden Stützenabschnitte aus ihrer fluchtenden Lage in die in Fig. 3 dargestellte abgeknickte Lage einfallen.

Zum Lösen der Verrastung, d.h. zum Schließen des Deckels 11, wird dieser über den Handgriff 21 wiederum angehoben und gleichzeitig der Entriegelungshandgriff 25 nach oben gedrückt. Dadurch wird, nachdem die obere Stirnfläche 41 des zweiten Stützenabschnitts 30 aus der schlitzförmigen Ausnehmung 34 frei ist, der erste Stützenabschnitt 29 wieder in eine fluchtende Position zum zweiten Stützenabschnitt gebracht, indem dann die untere Kante 43 des unteren Teils 32 an der Führungsbahn anliegt. Wenn jetzt der Deckel durch den Handgriff 21 wieder abgesenkt wird, dann läuft der erste Stützenabschnitt 29 in die Führung 39 des zweiten Stützenabschnittes ein, ohne dass die Raste 33 eingreift. Der Deckel kann dann abgesenkt werden, bis er wieder die Lage nach Fig. 4 erreicht hat.

Es ist zu erkennen, dass damit ein außerordentlich betriebssicherer und dennoch einfacher Mechanismus geschaffen wird, um den Deckel abzustützen und wieder abzusenken, wobei durch die Notwendigkeit der Bedienung zweier Handgriffe, nämlich des Deckelhandgriffs 21 und den Entriegelungshandgriffes 25, eine Zweihandbedienung erforderlich ist, die eine ungewollte Entriegelung so gut wie ausschließt.

## Patentansprüche

1. Verschlussdeckel für Prozessbehälter (13) zur Behandlung von elektronischen Bauteilen, wie Leiterplatten, mit einer insbesondere transparenten Deckelplatte (16), wobei der Deckel (11) gelenkig an dem Behälter (13) angelenkt ist und eine Deckelhandhabe (21) zur Öffnung und Aufstellung des Deckels (11) in eine Offnungsposition, sowie zwei Stützen (27) aufweist, die den Deckel (11) in der Öffnungsposition halten, wobei die Stützen (27) zwei am Deckel (11) bzw. den Behälter (13) angelenkte Stützenabschnitte (29, 30) aufweisen, die von einer verkürzten Schließposition der Stütze (27) in deren verlängerte Öffnungsposition beweglich sind und eine Raste (33) enthalten, die die Stütze (27) in der Öffnungsposition sichert, wobei die Raste (33) durch eine Fluchtungsänderung eines ersten Stützenabschnitts (29) gegenüber dem zweiten Stützenabschnitt (30) ein- bzw. ausrastbar ist und die ersten Stützenabschnitte (29) beider Stützen (27) durch ein Entriegelungsglied (40) miteinander verbunden sind, das eine Entriegelungshandhabe (25) aufweist.

2. Verschlussdeckel nach Anspruch 1, **dadurch gekennzeichnet, dass** die Deckelplatte (16) aus Glas besteht.

3. Verschlussdeckel nach Anspruch 1 oder 2, **dadurch gekennzeichnet, dass** die ersten Stützenabschnitte (29) in dem zweiten Stützenabschnitt (30) derart angeordnet und querbeweglich gelagert sind, dass die Raste (33) unter Schwerkrafteinwirkung in eine Rastposition einfällt.

4. Verschlussdeckel nach einem der vorhergehenden Ansprüche, **dadurch gekennzeichnet, dass** der Deckel (11) an dem von seiner Anlenkung (18) entfernten Rand (24) eine die Deckelhandhabe (21) aufweisende und die Stützen (27) sowie das Entriegelungsglied (40) schwenkbar lagernde Bedienungseinheit (19) aufweist, wobei vorzugsweise die Deckelplatte (16) im übrigen rahmenlos gehaltert ist.

5. Verschlussdeckel nach einem der vorhergehenden Ansprüche, **dadurch gekennzeichnet, dass** das Entriegelungsglied (40) entgegen einer Kraft, insbesondere der Schwerkraft, in eine Entriegelungsposition bewegbar ist.

6. Verschlussdeckel nach einem der vorhergehenden Ansprüche, **dadurch gekennzeichnet, dass** das Entriegelungsglied (40) eine Verbindungsstange (30) zwischen den ersten Stützenabschnitten (29) beider Stützen (27) ist und vorzugsweise deren Schwenkachsen verbindet oder bildet.

7. Verschlussdeckel nach einem der vorhergehenden Ansprüche, **dadurch gekennzeichnet, dass** der erste Stützenabschnitt (29) die Raste (33) in Form einer Randausnehmung (34) aufweist, die mit einer Endfläche (41) des zweiten Stützenabschnitts (30) rastend zusammenwirkt.

8. Verschlussdeckel nach einem der vorhergehenden Ansprüche, **dadurch gekennzeichnet, dass** der zweite Stützenabschnitt (30) eine Führung (39) für den ersten Stützenabschnitt (29) bildet und der erste Stützenabschnitt (29) im Bereich der Raste (33) innerhalb der Führung (39) zwischen einer Rastposition und einer Verschiebeposition querbeweglich ist, in der der erste Stützenabschnitt (29) zur Längsbewegung innerhalb des zweiten Stützenabschnittes (30) frei ist.

9. Verschlussdeckel nach Anspruch 8, **dadurch gekennzeichnet, dass** der erste Stützenabschnitt (29) innerhalb des zweiten Stützenabschnitts (30) zwischen der Rast- und der Verschiebeposition verschwenkbar ist, wobei vorzugsweise ein über die Raste (33) hinaus verlängerter, gegenüber der Führung (39) schmalerer Teil (32) des ersten Stützenabschnittes (29) mit einem verdickten Kopf (36) eine im zweiten Stützenabschnitt (30) längsverschiebbare Schwenkführung bildet.

10. Verschlussdeckel nach einem der vorhergehenden Ansprüche, **dadurch gekennzeichnet, dass** das Entriegelungsglied (40) nur in einer über die Öffnungsposition hinaus reichenden Entriegelungsposition zur Entriegelung betätigbar ist.

11. Verschlussdeckel nach einem der vorhergehenden Ansprüche, **dadurch gekennzeichnet, dass** die Raste (33) durch einen Hinterschnitt, insbesondere eine die Ausnehmung (34) begrenzende Rastnase (35), gegen Entriegelung in der Öffnungsposition gesichert ist.

12. Verschlussdeckel nach einem der vorhergehenden Ansprüche, **dadurch gekennzeichnet, dass** der erste Stützenabschnitt (29) aus einer Leiste mit seitlichem Rastausschnitt (34) und einem Kopf (36) am freien Ende besteht und im Bereich der von der Schwenkachse (18) des Deckels (11) entfernten Kante (24) des Deckels gelagert ist.

13. Verschlussdeckel nach einem der vorhergehenden Ansprüche, **dadurch gekennzeichnet, dass** der zweite Stützenabschnitt (30) ein wenigstens im Bereich einer durch in von ihm gebildeten Führungen (39) ein den ersten Stützenabschnitt (29) umfassendes, z.B. rechteckrohrförmiges Profil aufweist und an dem Behälter (13) bzw. einem daran angeordneten, die vom Deckel (11) verschließbare Öffnung (12) begrenzenden Rahmen (14) angelenkt ist.

## Claims

1. Closure lid for processing container (13) for processing electronic components, such as printed circuit boards, with an in particular transparent lid plate (16), the lid (11) being articulated in hinged manner to the container (13) and has a lid handle (21) for opening and raising the lid (11) into an opening position, as well as two supports (27) which hold the lid (11) in the opening position, the supports (27) having two support portions (29, 30) articulated to the lid (11), container (13) respectively, which are movable from a shortened closing position of support (27) into its extended opening position and contain a catch (33) securing support (27) in the opening position, the catch (33) being engageable/disengageable by an alignment change of a first support portion (29) relative to the second support portion (30) and the first support portions (29) of both supports (27) being interconnected by an unlocking member (40) having an unlocking handle (25).

2. Closure lid according to claim 1, **characterized in that** the lid plate (16) is made from glass.

3. Closure lid according to claims 1 or 2, **characterized in that** the first support portions (29) are so arranged and transversely movably mounted in the second support portion (30) that the catch (33) drops into a locking position under gravity action.

4. Closure lid according to one of the preceding claims, **characterized in that** on its margin (24) remote from its articulation (18) the lid (11) has an operating unit (19) provided with the lid handle (21) and pivotably mounting the unlocking member (40) and supports (27), the lid plate (16) being preferably otherwise held in frameless manner.

5. Closure lid according to one of the preceding claims, **characterized in that** the unlocking member (40) is movable into an unlocking position counter to a force, particularly gravity.

6. Closure lid according to one of the preceding claims, **characterized in that** the unlocking member (40) is a connecting rod (30) between the first support portions (29) of both supports (27) and preferably connects or forms their pivoting axes.

7. Closure lid according to one of the preceding claims, **characterized in that** the first support portion (29) has the catch (33) in the form of a marginal recess (34), which cooperates in locking manner with an end face (41) of the second support portion (30).

8. Closure lid according to one of the preceding claims, **characterized in that** the second support portion (30) forms a guide (39) for the first support portion (29) and, in the vicinity of catch (33) within guide (39), the first support portion (29) is transversely movable between a locking position and a displacement position in which the first support portion (29) is free for moving longitudinally within the second support portion (30).

9. Closure lid according to claim 8, **characterized in that** the first support portion (29) is pivotable between the locking and displacement position within the second support portion (30) and preferably part (32) of the first support portion (29) with a thickened head (36) and extended beyond the catch (33) and narrower than guide (39) forms a pivoting guide longitudinally displaceable in the second support portion (30).

10. Closure lid according to one of the preceding claims, **characterized in that** the unlocking member (40) is only operable for unlocking purposes in an unlocking position extending beyond the opening position.

11. Closure lid according to one of the preceding claims, **characterized in that** the catch (33) is secured by an undercut, particularly a detent (35) bounding the recess (34) so as to prevent unlocking in the opening position.

12. Closure lid according to one of the preceding claims, **characterized in that** the first support portion (29) comprises a ledge with a lateral locking cutout (34) and a head (36) at the free end and is mounted in the vicinity of the lid edge (24) remote from pivoting axis (18) of lid (11).

13. Closure lid according to one of the preceding claims, **characterized in that** the second support portion (30) has an e.g. rectangular tubular profile embracing the first support portion (29) at least in the vicinity of guides (39) formed by it and is articulated to container (13) or a frame (14) located thereon and bounding the opening (12) closable by lid (11).

## Revendications

1. Couvercle de fermeture pour cuves de traitement (13) pour le traitement de composants électroniques, comme des plaques à circuit imprimé, avec une plaque de couvercle (16) notamment transparente, sachant que le couvercle (11) est attaché de manière articulée au récipient (13) et qu'il présente une manette de couvercle (21) pour ouvrir et lever le couvercle (11) en une position ouverte ainsi que deux supports (27), qui maintiennent le couvercle (11) quand il se trouve en position ouverte, sachant que les deux supports (27) présentent deux parties de support (29, 30) qui sont attachées de manière articulée au couvercle (11) ou encore au récipient (13) et qui peuvent être déplacées d'une position fermée plus courte du support (27) dans sa position ouverte plus longue et qui comprennent un cran d'arrêt (33), qui assure le support (27) dans la position ouverte, sachant que le cran d'arrêt (33) peut être enclenché et désenclenché par un changement d'alignement d'une première partie de support (29) par rapport à une deuxième partie de support (30) et que les premières parties de support (29) des deux supports (27) sont raccordées entre elles par un élément de déverrouillage (40), qui présente une manette de déverrouillage (25).

2. Couvercle de fermeture d'après la revendication 1, **caractérisé en ce que** la plaque de couvercle (16) est en verre.

3. Couvercle de fermeture d'après la revendication 1 ou 2, **caractérisé en ce que** les premières parties de support (29) sont disposées et logées de manière transversalement déplaçable dans la deuxième partie de support (30), que les crans d'arrêt (33) tombent dans une position d'arrêt par l'effet de la force gravitationnelle.

4. Couvercle de fermeture d'après une des revendications précédentes, **caractérisé en ce que** le couvercle (11) présente à son bord (24) éloigné de son attache (18) une unité de commande (19) logée de manière pivotable présentant la manette de couvercle (21) et les supports (27) ainsi que l'élément de déverrouillage (40), sachant que de préférence la plaque de couvercle (16) est maintenue pour le reste sans cadre.

5. Couvercle de fermeture d'après une des revendications précédentes, **caractérisé en ce que** l'élément de déverrouillage (40) est déplaçable en une position désenclenchée contre l'effet d'une force, notamment contre l'effet de la force gravitationnelle.

6. Couvercle de fermeture d'après une des revendications précédentes, **caractérisé en ce que** l'élément de déverrouillage (40) est une tige de raccordement (30) entre les premières parties de support (29) des deux supports (27) et qu'elle raccorde ou qu'elle forme leurs axes de pivotement.

7. Couvercle de fermeture d'après une des revendications précédentes, **caractérisé en ce que** la première partie de support (29) présente le cran d'arrêt (33) sous forme d'un évidement au bord (34), qui agit conjointement à enclenchement avec une surface terminale (41) de la deuxième partie de support (30).

8. Couvercle de fermeture d'après une des revendications précédentes, **caractérisé en ce que** la deuxième partie de support (30) forme un guidage (39) pour la première partie de support (29) et que la première partie de support (29) est transversalement déplaçable dans le domaine du cran d'arrêt (33) à l'intérieur du guidage (39) entre une position d'arrêt et une position de déplacement, où la première partie de support (29) est libre de se déplacer en direction longitudinale à l'intérieur de la deuxième partie de support (30).

9. Couvercle de fermeture d'après la revendication 8, **caractérisé en ce que** la première partie de support (29) peut être pivotée à l'intérieur de la deuxième partie de support (30) entre la position d'arrêt et la position de déplacement, sachant que de préférence une partie (32) de la première partie de support (29) prolongée au-delà du cran d'arrêt et plus mince par rapport au guidage (39) forme avec une tête (36) épaissie un guidage pivotant déplaçable en direction longitudinale dans la deuxième partie de support (30).

10. Couvercle de fermeture d'après une des revendications précédentes, **caractérisé en ce que** l'élément de déverrouillage (40) ne peut être actionné pour une action de déverrouillage que dans une position de déverrouillage qui s'étend au-delà de la position ouverte.

11. Couvercle de fermeture d'après une des revendications précédentes, **caractérisé en ce que** le cran d'arrêt (33) est assuré contre un déverrouillage en position ouverte par une contre-dépouille, notamment par un ergot (35) délimitant l'évidement (34).

12. Couvercle de fermeture d'après une des revendications précédentes, **caractérisé en ce que** la première partie de support (29) est constituée d'une baguette présentant un évidement d'arrêt (34) latéral et d'une tête (36) à son extrémité libre et qu'elle est logée dans le domaine de l'arête (24) du couvercle éloignée de l'axe de pivotement (18) du couvercle (11).

13. Couvercle de fermeture d'après une des revendications précédentes, **caractérisé en ce que** la deuxième partie de support (30) présente, au moins dans le domaine d'un des guidages (39) qu'elle constitue, un profil par exemple rectangulaire, entourant la première partie de support (29), et qu'elle est fixée de manière articulée au récipient (13) ou encore à un cadre (14) disposé sur celui-ci, qui délimite l'ouverture (12) pouvant être fermée par le couvercle (11).
